**Europäisches Patentamt**

**European Patent Office**

**Office européen des brevets**

(11) Veröffentlichungsnummer: **0 119 472**
**A2**

(12) # EUROPÄISCHE PATENTANMELDUNG

(21) Anmeldenummer: 84101578.7

(22) Anmeldetag: 16.02.84

(51) Int. Cl.³: **G 03 F 7/26**

(30) Priorität: 21.02.83 DE 3305934

(43) Veröffentlichungstag der Anmeldung: 26.09.84
Patentblatt 84/39

(84) Benannte Vertragsstaaten: **CH DE FR GB LI NL**

(71) Anmelder: **Siemens Aktiengesellschaft, Berlin und München Wittelsbacherplatz 2, D-8000 München 2 (DE)**

(72) Erfinder: **Sigusch, Reiner, Dipl.-Ing., Mainaustrasse 71, D-8000 München 60 (DE)**
Erfinder: **Wipper, Ludwig, Ing. grad., Kurfürstenstrasse 8, D-8034 Germering (DE)**

(54) Vorrichtung zur Temperaturbehandlung von Substraten, insbesondere von Halbleiterkristallscheiben.

㉗ Die Erfindung betrifft eine Vorrichtung zur Temperaturbehandlung von Substraten, insbesondere von Halbleiterkristallscheiben, bestehend aus einem Träger (1) für die Aufnahme der zu behandelnden Substrate (2), eine den Träger (1) aufnehmende rahmenförmige Halterung (3), die mit einem zeitgesteuerten Druckluftzylinder (5) gekoppelt und axial über eine Führung (6) verschiebbar ist und einer Heizeinrichtung. Die Heizeinrichtung ist mit einer Vakuumansaugvorrichtung (8) gekoppelt und enthält mehrere rondenförmige Heizplatten (7), gegen die die im Träger (1) befindlichen Substrate (2) gesaugt werden. Die Vorrichtung wird verwendet für Niedrigtemperaturprozesse in der Halbleitertechnologie, insbesondere bei Fotolithographieprozessen, und erspart unnötige Umhordvorgänge.

SIEMENS AKTIENGESELLSCHAFT      Unser Zeichen
Berlin und München        /1      VPA
83 P 1 0 8 9 E

Vorrichtung zur Temperaturbehandlung von Substraten,
insbesondere von Halbleiterkristallscheiben.

Die Erfindung betrifft eine Vorrichtung zur Temperaturbehandlung von Substraten, insbesondere von Halbleiterkristallscheiben, wie sie zum Beispiel im Zuge der Fertigung von integrierten Schaltungen verarbeitet werden.

In der Mikroelektronik werden zur Herstellung von integrierten Schaltungen Strukturen bis in den Submikrometer-
Bereich auf Substraten wie zum Beispiel Silizium-Einkristallscheiben durch Fotolithographieprozesse erzeugt.
Zu diesem Zweck werden die Substrate gereinigt und eventuell getempert, um die Substratoberfläche von störenden
Rückständen zu befreien. Zur besseren Fotolackhaftung
werden sie einer Haftvermittlerbehandlung ausgesetzt. Anschließend werden die Substrate mit einer Fotolackschicht
versehen, welcher in einem nachfolgenden Ausbackprozeß,
zum Beispiel bei einer Temperatur von 85°C, der größte
Teil des Lösungsmittels entzogen wird. Die Fotolackschichten werden auch nach der Belichtung und vor oder
nach der Entwicklung der in ihr erzeugten Strukturen
verschiedenen Temperaturbehandlungen unterzogen.

Für solche Temperaturbehandlungen ist es üblich, die
Substrate in einen Umluftofen zu erwärmen oder die Wärme
durch eine induktive Heizung der Vor- oder Rückseite der
Substratscheiben zuzuführen. Eine weitere Möglichkeit zum
Vor- oder Nachbacken von mit Fotolack beschichteten Substratscheiben ist durch eine Kontaktheizung von der Rückseite der Kristallscheibe her gegeben. Für diese Tempera-

Edt 1 Plr/28.1.1983

turbehandlungen werden die mit der Fotolackschicht versehenen Halbleiterkristallscheiben einzeln oder in Kassetten manuell oder automatisch durch den Vorbackprozeß geführt.

Die Erfindung dient zur Lösung der Aufgabe, die Temperaturbehandlungsprozesse in der Fotolithographietechnologie bei der Fertigung von integrierten Halbleiterschaltungen rationell zu gestalten und insbesondere ein Umhorden zwischen den einzelnen Verfahrensschritten zu vermeiden. Außerdem soll auch gewährleistet werden, daß ein sehr sauberes Arbeiten ohne Abrieb von Fotolack oder Metallteilchen möglich ist. Die beim Abrieb entstehenden Partikelchen bzw. metallischen Verunreinigungen führen zu fehlerhaften Strukturen und damit zu Ausbeuteverlusten bei der Herstellung der integrierten Schaltung.

Die erfindungsgemäße Aufgabe wird durch eine Vorichtung der eingangs genannten Art gelöst, welche durch folgende Merkmale gekennzeichnet ist:

a) einen Träger, in dem die Substrate angeordnet sind,

b) eine, den Träger mit den Substraten aufnehmende, rahmenförmige Halterung, die mit einem zeitgesteuerten Druckluftzylinder gekoppelt und über eine Führung axial verschiebbar ist,

c) eine unterhalb der mit dem Träger bestückten rahmenförmigen Halterung angeordneten, temperaturgeregelten Heizvorrichtung und

d) einer mit der Heizvorrichtung gekoppelten Vakuum-Ansaugvorrichtung.

In einer Weiterbildung des Erfindungsgedankens ist vorgesehen, daß der Träger für die Aufnahme der Substrate dem

0119472

Durchmesser der Substrate angepaßte kreisförmige
Ausschnitte aufweist, die mit Mitteln versehen sind,
durch welche die Substrate in den kreisförmigen
Ausschnitten gehalten werden. Dies kann durch am
Kreisausschnittrand symmetrisch zueinander angeordnete
Haltestifte oder in dem Kreisausschnittrand angeordnete
ringförmige Halterungen erfolgen.

Zur Fixierung des mit den Substraten bestückten Trägers
in x/y-Richtung sind in der rahmenförmigen Halterung auf
der einen Seite Anschlagstifte für prismenförmige Ausschnitte im Träger und auf der Gegenseite ein keilförmiges Anschlagstück angeordnet.

Die Heizvorrichtung weist entsprechend der Anzahl der im
Träger angeordneten Substrate unabhängig voneinander regelbare, rondenförmige, den Abmessungen der Substrate angepaßte Heizplatten auf, deren Auflageflächen mit einer
Schicht aus einer Aluminium-Magnesium-Silizium-Legierung
versehen sind (aluminium-hard-coating).

Um einen besonders guten Kontakt der Substrate auf den
Heizplatten zu erzielen, sind in den rondenförmigen Heizplatten rillenförmige Öffnungen für die Vakuumabsaugung
vorgesehen. Die Substrate werden mittels Vakuum gegen die
Heizplatten gesaugt, so daß innerhalb von zwei Sekunden
ein sehr gut reproduzierbarer Wärmeübergang erfolgt. Die
Verweilzeit der Substrate auf den Heizplatten wird automatisch gesteuert, und zwar mit einer absoluten Genauigkeit von weniger als einer Sekunde (Ausbackzeit ca. 1
Minute).

Die Vorrichtung ist für alle Niedrigtemperaturprozesse
(bis 400°C) einsetzbar.

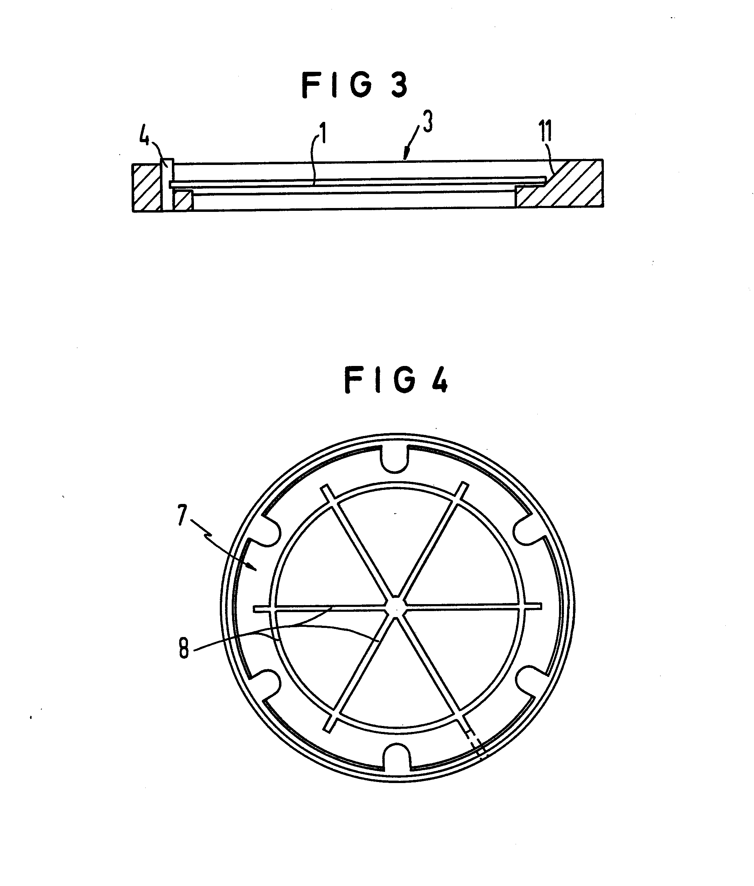

Weitere Einzelheiten sind aus den Figuren 1 bis 4 zu entnehmen.

Dabei zeigt

die Figur 1 in schematischer Darstellung ein Schnittbild durch eine erfindungsgemäße Vorrichtung,

die Figur 2 die entsprechende Draufsicht,

die Figur 3 ein Schnittbild durch die mit dem Träger bestückte Halterung und

die Figur 4 eine Draufsicht auf die Heizplatte mit den
Rillen für die Vakuumansaugung.

Die eingezeichneten Pfeile zeigen Bewegungsrichtungen an.

In den Figuren gelten folgende Bezugszeichen:

1 = Träger
2 = Substrat zum Beispiel Halbleiterkristallscheiben
3 = rahmenförmige Halterung
4 = Anschlagstifte in der rahmenförmigen Halterung
5 = zeitgesteuerter Druckzylinder
6 = Rollenführung
7 = Heizplatten, temperaturgeregelt $\pm$ 1°C
8 = rillenförmige Öffnungen für Vakuumansaugen
9 = Haltestifte für die Kristallscheiben im Träger (1)
10 = prismenförmige Ausschnitte im Träger für die Fixierung in der Halterung (3) mittels Anschlagstifte (4)
11 = keilförmiges Anschlagstück in der rahmenförmigen
Halterung.

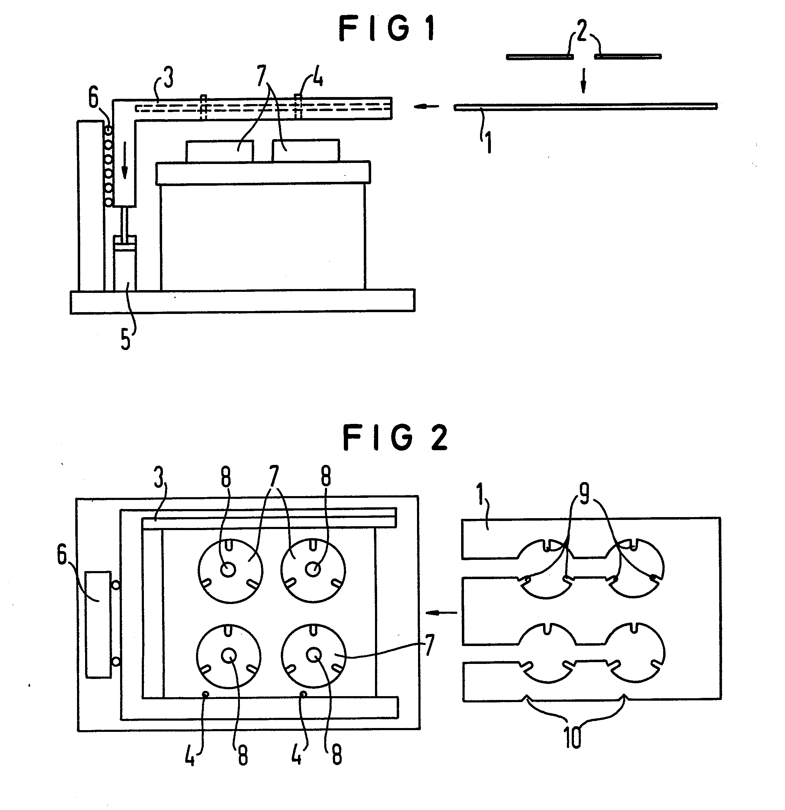

Wie insbesondere aus Figur 2 ersichtlich ist, enthält die
Anordnung vier Heizplatten (7). Dies ergibt sich vorteilhaft in Verbindung mit einer im Handel erhältlichen Vierfachzentrifuge (Typ AC 201 der Firma Headway/Garland,
USA). Durch die Vierfachgestaltung des Trägers kann für
die Belackung und das Ausbacken der Kristallscheiben ein

0119472
83 P 1089 E

und derselbe Träger verwendet werden. Ein Umhorden entfällt.

Der Arbeitsablauf für einen Vorbackprozeß gestaltet sich wie folgt:

1. Träger in Belackungsvorrichtung bringen und automatisch mit Halbleiterkristallscheiben bestücken, (nicht dargestellt).

2. Bestückten Träger (1, 2) in die Halterung (3) der erfindungsgemäßen Vorrichtung einsetzen.

3. Startknopf betätigen.

4. Kristallscheiben werden pneumatisch auf die Heizplatten (7) aufgelegt und durch Vakuum angesaugt (8).

5. Nach Ablauf der vor dem Betätigen des Startknopfes eingestellten Trockenzeit erfolgt automatisches Abheben der getrockneten Scheiben.

6. Träger mit Kristallscheiben (1, 2) von Halterung (3) entfernen.

10 Patentansprüche
4 Figuren

0119472
83 P 1089 E

Patentansprüche

1. Vorrichtung zur Temperaturbehandlung von Substraten, insbesondere von Halbleiterkristallscheiben, wie sie im Zuge der Fertigung von integrierten Schaltungen verarbeitet werden, g e k e n n z e i c h n e t  d u r c h

a) einen Träger (1), in dem die Substrate (2) angeordnet sind,

b) eine, den Träger (1) mit den Substraten (2) aufnehmende rahmenförmige Halterung (3), die mit einem zeitgesteuerten Druckluftzylinder (5) gekoppelt und über eine Führung (6) axial verschiebbar ist,

c) eine unterhalb der mit dem Träger (1) bestückten rahmenförmigen Halterung (3) angeordnete temperaturgeregelte Heizvorrichtung (7) und

d) eine mit der Heizvorrichtung (7) gekoppelte Vakuum-Ansaugvorrichtung (8).

2. Vorrichtung nach Anspruch 1, d a d u r c h  g e - k e n n z e i c h n e t , daß der Träger (1) für die Aufnahme der Substrate (2) dem Durchmesser der Substrate (2) angepaßte kreisförmige Ausschnitte aufweist, die mit Mitteln (9) versehen sind, durch welche die Substrate (2) in den kreisförmigen Ausschnitten gehalten werden und daß auf einer Seite des Trägers (1) prismenförmige Ausschnitte (10) angebracht sind, mit deren Hilfe der Träger (1) in der Halterung (3) ausgerichtet wird.

3. Vorrichtung nach Anspruch 1 und 2, d a d u r c h  g e k e n n z e i c h n e t , daß in der rahmenförmigen Halterung (3) zur Fixierung des Trägers (1) in x/y-Richtung auf der einen Seite Anschlagstifte (4) für die prismenförmigen Ausschnitte (10) und auf der Gegenseite ein

0119472
83 P 1089 E

keilförmiges Anschlagstück (11) angebracht ist.

4. Vorrichtung nach Anspruch 1 bis 3, d a d u r c h g e k e n n z e i c h n e t , daß am Kreisausschnittrand im Träger (1) symmetrisch zueinander angeordnete Haltestifte (9) für die Substrate (2) angeordnet sind.

5. Vorrichtung nach Anspruch 1 bis 3, d a d u r c h g e k e n n z e i c h n e t , daß zur Halterung der Substrate (2) in den Kreisasuschnitten des Trägers (1) ringförmige Halterungen vorgesehen sind.

6. Vorrichtung nach einem der Ansprüche 1 bis 5, d a - d u r c h g e k e n n z e i c h n e t , daß die Heizvorrichtung entsprechend der Anzahl der im Träger (1) angeordneten Substrate (2) unabhängig voneinander regelbare, rondenförmige, den Abmessungen der Substrate (2) angepaßte Heizplatten (7) aufweist.

7. Vorrichtung nach Anspruch 6, d a d u r c h g e - k e n n z e i c h n e t , daß vier Heizplatten (7) vorgesehen sind.

8. Vorrichtung nach einem der Ansprüche 1 bis 7, d a - d u r c h g e k e n n z e i c h n e t , daß die Auflagefläche der Heizplatten (7) und die Oberfläche des Trägers (1) mit einer Schicht aus einer Aluminium-Magnesium-Silizium-Legierung versehen sind.

9. Vorrichtung nach einem der Ansprüche 1 bis 8, d a - d u r c h g e k e n n z e i c h n e t , daß für die Vakuumabsaugung in den rondenförmigen Heizplatten (7) rillenförmige Öffnungen (8) vorgesehen sind.

10. Vorrichtung nach einem der Ansprüche 1 bis 9, d a - d u r c h g e k e n n z e i c h n e t , daß Mittel vorgesehen sind, durch welche eine automatische Steuerung

0119472

der Verweilzeit der Substrate (2) in der Heizvorrichtung einstellbar ist.

FIG 1

FIG 2

## FIG 3

## FIG 4